Europäisches Patentamt

European Patent Office

Office europeen des brevets

Numero de publication **0 156 656**

**A1**

# DEMANDE DE BREVET EUROPEEN

(21) Numero de depr 85400020 5

(22) Date de dépôt: 08.01.85

(51) Int Cl⁴ **H 02 J 7/14**
**G 01 R 31/36**

(30) Priorite 01 03 84 FR 8403200

(43) Date de publication de la demande:
02 10.85 Bulletin 85/40

(84) Etats contractants designes
**DE GB IT**

(71) Demandeur **DUCELLIER ET CIE**
**3/5 Voie Félix Eboué**
**F-94000 Creteil(FR)**

(72) Inventeur: **Lheritier, Jean Pierre**
**2 rue Roger Milon**
**F-94310 Orly(FR)**

(74) Mandataire: **Habert, Roger**
**VALEO Service Propriété Industrielle21 rue Auguste**
**Blanqui**
**F-93406 Saint Ouen(FR)**

(54) Dispositif témoin de charge d'une batterie de véhicule automobile.

(57) Ce dispositif est caractérisé en ce qu'il comporte des moyens de commande de la couleur d'un témoin lumineux, tel qu'une diode bichromique (41), qui emet une lumière verte en cas de bon fonctionnement, orange en cas de défaut minime tel que tension de batterie insuffisante, rouge en cas de défaut vital tel que surcharge de la batterie ou rupture de la courroie de l'alternateur et en ce qu'il est indépendant du regulateur électronique de type monofonction du véhicule.

_FIG 1_

EP 0 156 656 A1

- 1 -                    **0156656**

DISPOSITIF TEMOIN DE CHARGE D'UNE BATTERIE DE VEHICULE AUTOMOBILE

La présente invention concerne un dispositif témoin de charge d'une batterie de véhicule automobile, chargée par un alternateur dont le rotor est entraîné en rotation par un élément du moteur du véhicule par l'intermédiaire d'une courroie et dont le bobinage d'excitation est commandé par un régulateur électronique régulant la tension de batterie.

Les témoins de charge d'une batterie connus sont constitués par une partie des éléments constitutifs du régulateur ; ce dernier devenu multifonction est alors de conception délicate et chacune de ses fonctions, tributaire d'une autre, est de fiabilité incertaine, et plus particulièrement la fonction de régulation. Afin d'assurer une régulation fiable, les constructeurs automobiles tendent à utiliser à nouveau des régulateurs, dits monofonction, qui n'assurent donc que la régulation de la tension de batterie en commandant l'excitation de l'alternateur, il n'est donc plus possible d'utiliser des éléments du régulateur pour avoir une signalisation de l'état de charge de la batterie.

De plus les témoins connus ne signalent pas le niveau d'importance d'un défaut existant dans le dispositif de charge de la batterie, ce qui parfois entraine un arrêt impératif inutile du véhicule tel que pour une signalisation de sous charge de la batterie. Il est donc important de qualifier le défaut en différenciant les signaux du témoin suivant que le défaut nécessite ou non un arrêt impératif du véhicule.

Certains consommateurs, connectés directement aux bornes de la batterie, tels que les veilleuses, agissent sur la charge de la batterie; il peut alors être avantageux que le témoin de charge signale leur état avant qu'ils n'aient eu le temps de décharger la batterie lorsque le moteur est à l'arrêt. De plus l'intensité lumineuse du témoin peut être trop importante et suivant l'état du dispositif d'éclairage du véhicule il est avantageux de la moduler.

La présente invention a pour but de remédier aux inconvénients précités et concerne à cet effet un dispositif témoin de charge d'une batterie de véhicule automobile, dont le dispositif de charge comporte notamment un alternateur entraîné en rotation par une courroie elle même entraînée par un élément rotatif du moteur du véhicule et qui comporte un bobinage d'excitation commandé par un régulateur du type monofonction n'assurant que la régulation de la tension de la batterie, dispositif caractérisé en ce qu'il est connecté entre la clé de contact du véhicule, la masse et une phase de l'alternateur et comporte un témoin lumineux à intensité lumineuse variable et à couleur variable suivant l'importance d'un défaut éventuel du dispositif de charge ; des moyens de commande de la variation de l'intensité lumineuse du témoin lumineux et des moyens de commande de la variation de la couleur dudit témoin lumineux.

La description qui va suivre en regard des schémas annexés fera mieux comprendre comment l'invention peut être réalisée.

La figure 1 représente un mode de réalisation d'un témoin de charge d'une batterie conforme à l'invention.

La figure 2 représente un autre mode de réalisation d'un témoin conforme à l'invention.

Dans les modes de réalisation décrits ci-après l'alternateur porte le repère 44, la clé de contact du véhicule le repère 42 et les veilleuses le repère 43.

Conformément à l'invention le témoin est connecté entre la clé de contact 42 et la masse, et reçoit une information venant d'une des phases de l'alternateur 44 et · est constitué essentiellement d'un témoin lumineux 41 ou 50 dont la couleur varie suivant le défaut à signaler, par l'intermédiaire d'un circuit de commande auquel sont appliquées une tension de référence, la tension de batterie et par un circuit de témoin de courroie cassée 70, la tension intégrée d'une phase de l'alternateur 44, et dont l'intensité lumineuse varie par un dispositif 80 connecté aux veilleuses 43.

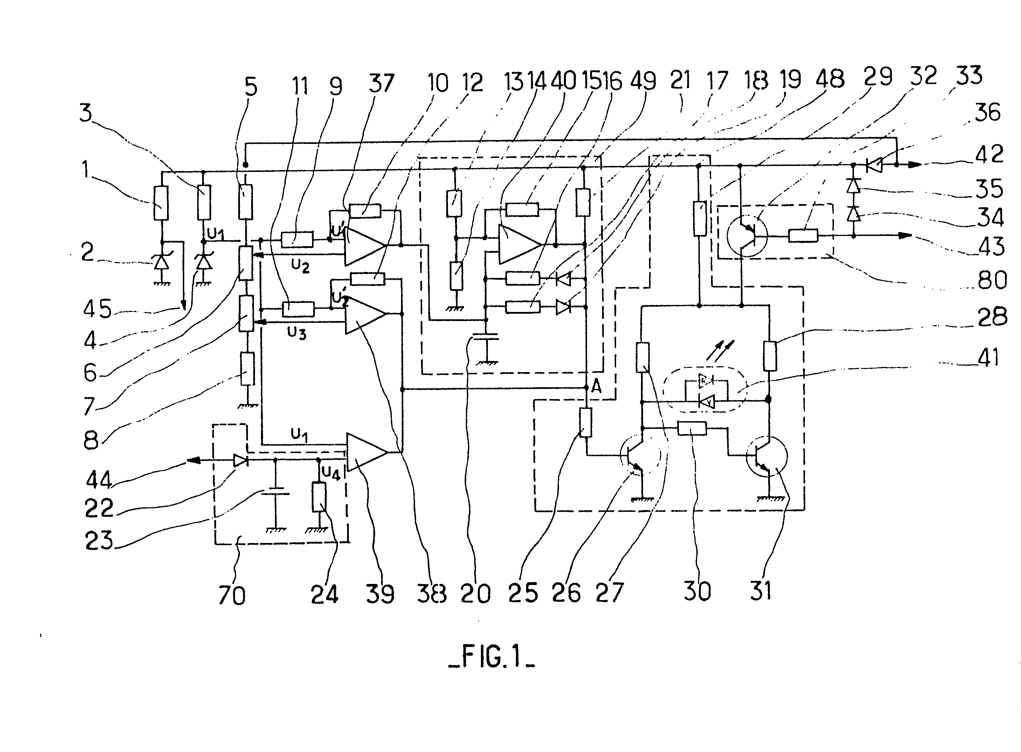

Dans un premier mode de réalisation présenté à la figure 1, le témoin lumineux est une diode électroluminescente bichromique 41 qui lorsqu'elle est traversée dans un sens par un courant émet une couleur verte, dans l'autre sens une couleur rouge, et par un courant alternatif une couleur orange.

Le circuit de commande de la diode 41 se compose d'une part de deux transistors 26 et 31 et de résistances 21,25,27,28,29,30 et d'autre part d'un circuit de commande du transistor 26 composé de comparateurs 37 à 39, et de résistances 9 à 12 et d'un oscillateur constitué d'un comparateur 40, d'un condensateur 20, de diodes 18 et 19 et de résistances 13 à 17.

Les quatres comparateurs 37 à 40 font avantageusement partie d'un même circuit intégré 45 de type commercial LN 3302 et sont alimentés par une alimentation stabilisée constituée de façon connue d'une résistance 1 et d'une diode 2 du type Zener assurant en plus la protection contre les surtensions.

A partir d'une tension de référence constante $U1$ prélevée entre une résistance 3 et une diode 4 du type Zener, une tension de seuil est appliquée à l'entrée des comparateurs 37,38 et 39 sous la forme $U1$ au comparateur 39, $U'1$ au 37 et $U'2$ au 38. Un pont de résistances 5 et 8 et de potentiomètres 6 et 7 définit deux tensions $U_2$ $U_3$, proportionnelles à la tension de la batterie, appliquées respectivement à l'entrée des comparateurs 37 et 38. La tension $U_4$ de phase de l'alternateur est appliquée à l'entrée du comparateur 39 par l'intermédiaire d'une diode 22, d'un condensateur 23 et d'une résistance 24.

L'oscillateur délivre des signaux carrés de fréquence et de rapport cyclique ajustable. Le réglage de la fréquence s'effectue par le condensateur 20 et les résistances 16,17 lesquelles permettent aussi de régler le rapport cyclique.

Le fonctionnement d'un tel dispositif est alors le suivant : Lorsque la tension de batterie est normale la tension $U_2$ prélevée sur le potentiomètre 6 est supérieure à la tension de seuil $U'1$

Le comparateur 37 se sature et vient bloquer l'oscillateur en position haute, c'est à dire que le signal en A à la sortie de l'oscillateur est à l'état "1". La base du transistor 26 est alimentée et conséquemment la base du transistor 31 ne l'est pas ; le courant traverse donc la diode 41 à travers les résistances 29 et 28 et le collecteur-émetteur du transistor 26 et émet une lumière verte.

Les résistances 9 et 10 donnent une légère hystérésis au comparateur 37 afin d'éviter une oscillation en A lorsque les tensions $U'1$ et $U_2$ sont identiques.

Pour une tension batterie supérieure à la normale, la tension $U_3$ prélevée au potentiomètre 7 est supérieure à $U'2$, la sortie du comparateur 38 se sature, mettant le point A à la masse, c'est à dire à l'état "∅". La base du transistor 26 est à la masse, la base du transistor 31 est alimentée à travers la résistance 30. Le courant traverse la diode 41 à travers les résistances 29 et 27 et le collecteur-émetteur du transistor 31 et émet une lumière rouge.

Comme pour le comparateur 37, les résistances 11 et 12 donne une légère hystérésis au comparateur 38.

Pour une tension inférieure à la normale la tension $U_2$ devient inférieure à la tension de seuil $U'_1$ , le comparateur 37 alimente l'oscillateur qui fournit en A un signal oscillant entre l'état "1" et l'état "$\emptyset$", de ce fait alternativement la diode 41 émet un signal vert puis rouge suivant une fréquence telle que la lumière émise semble orange.

Dans le cas d'une rupture de courroie de l'alternateur la tension de phase de l'alternateur 44 disparaît, le condensateur 23 du circuit 70 se décharge progressivement par la résistance 24, le temps de décharge représentant la constante de temps à l'allumage du voyant, aussi lorsque la tension $U_4$ aux bornes du condensateur 23 est inférieure à la tension de référence $U_1$, la sortie du comparateur 39 se sature, le signal obtenu en A est alors bloqué à l'état "1" et conséquemment la diode 41 émet une lumière rouge.

La diode 41 émet donc une lumière soit rouge, ou verte ou orange d'une certaine intensité lumineuse, qui contraste avec l'éclairage extérieur, or lorsque l'éclairage extérieur nécessite l'emploi des veilleuses le contraste devient trop important ce qui fatigue l'utilisateur, en conséquence le dispositif 80 assure la diminution de cette intensité lumineuse dès que les veilleuses 43 sont allumées. Ce dispositif 80 est constitué d'un transistor 32 du type PNP dont l'émetteur collecteur est disposé en parallèle avec la résistance 29 et dont la base est alimentée par les veilleuses à travers une résistance 33. A l'arrêt l'état des veilleuses doit être signalé. Il est donc avantageux d'utiliser la diode 41 pour signaler l'état desdites veilleuses 43. Pour ce faire deux diodes en série 34 et 35 sont disposées dans leur sens passant entre les veilleuses et le fil d'alimentation du témoin de charge entre la clé 42 et le témoin de charge et une diode 36 est disposée sur ce fil d'alimentation entre la clé 42 et les diodes 34,35 dans le sens passant de la clé vers le témoin de charge afin d'éviter la bouclage de l'alimentation des veilleuses 43 sur le réseau positif de la clé de contact 42.

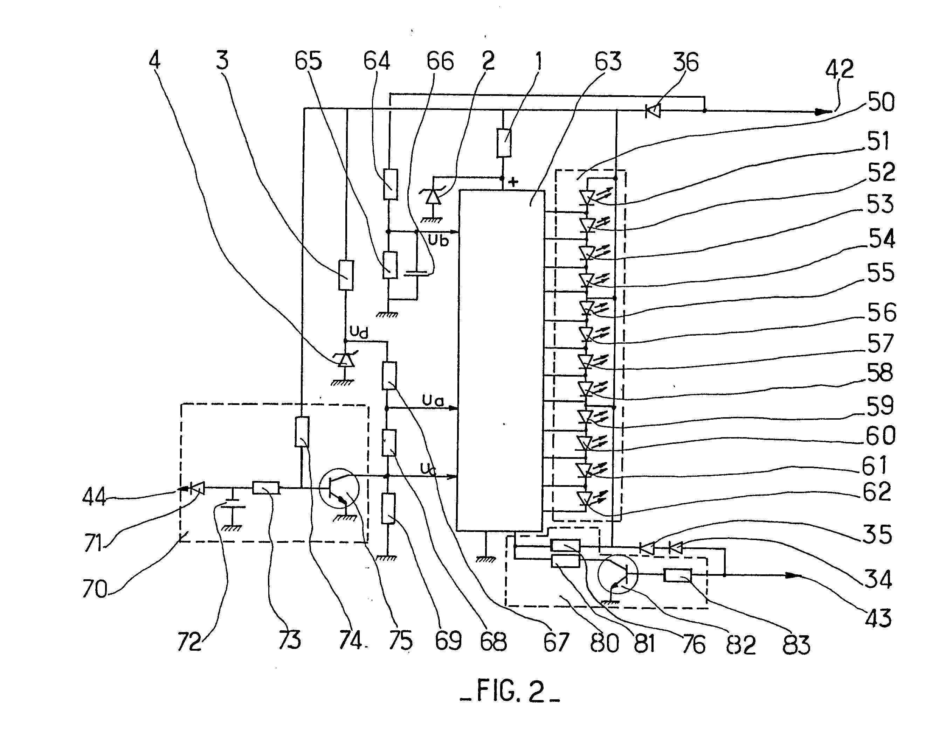

Dans un second mode de réalisation représenté à la fig.2 le témoin lumineux est une rampe 50 de diodes électroluminescentes 51 à 62, divisée en trois groupes de quatre diodes ; les diodes 51 à 54 de couleur jaune, les diodes 55 à 58 de couleur verte et les diodes 59 à 62 de couleur rouge.

Le circuit de commande de la rampe lumineuse 50 comporte un analyseur 63 qui se présente sous la forme d'un circuit intégré, du type UAA 180 (Siemens) et qui après analyse de la tension de batterie $U_b$ allume progressivement de une à douze les diodes 51 à 62 en fonction de l'évolution de cette tension $U_b$ appliquée à son entrée. Cette tension représentative de la tension batterie est délivrée par l'intermédiaire d'un pont diviseur de tension formé des résistances 64 et 65 branchées entre la clé de contact 42 et la masse, un condensateur 66 sert de filtrage à cette tension. Cette tension batterie $U_b$ est comparée à deux tensions de références $U_a$ et $U_c$ qui sont prélevées sur un pont diviseur constitué par des résistances 67,68 et 69 branchées en série entre la masse et une tension régulée $U_d$ délivrée par une diode Zener 4 et une résistance 3 disposées en série entre la masse et la clé de contact 42.

Le circuit intégré 63 est alimenté par une alimentation stabilisée constituée par une résistance 1 et une diode Zener 2 et qui assure en plus la protection du circuit 63 contre les surtensions.

Le fonctionnement d'un tel dispositif est alors le suivant : Lorsque la tension $U_b$ est inférieure à la tension $U_a$ toutes les diodes sont éteintes, par contre dès que la tension $U_b$ atteint la tension $U_c$ toutes les diodes sont allumées : La quantité de diodes allumées est alors fonction de la variation de la tension $U_b$ entre les valeurs $U_a$ et $U_c$, la couleur détermine l'importance d'un défaut éventuel du dispositif de charge.

Le dispositif 70 intégrateur de la tension d'une phase de l'alternateur 44 est constitué par une diode 71, un condensateur 72 un transistor 75 équipé de ses résistances de charge 73 et 74. Lorsque l'alternateur tourne les parties légèrement négatives du signal recueilli sur une des phases de l'alternateur, déchargent le condensateur 72 par l'intermédiaire de la diode 71, ce qui bloque le transistor 75 laissant la tension Uc à sa valeur de référence et ainsi le dispositif fonctionne normalement.

Lorsque la courroie d'alternateur est cassée, l'alternateur 44 s'arrête de tourner, le condensateur 72 se charge par l'intermédiaire des résistances 74 et 73 provoquant la saturation du transistor 75, la tension de référence Uc est alors mise à la masse provoquant l'allumage de toutes les diodes électroluminescentes 51 à 62 indiquant la nécéssité impérative de s'arrêter.

Dans cette réalisation le dispositif 80 témoin de l'état des veilleuses 43 est constitué par un transistor 82 et des résistances 76, 81 et 83. Le circuit émetteur-collecteur du transistor 82 est connectée en série avec la résistance 81, cet ensemble étant connecté entre la masse et le circuit intégré 63, la base du transistor 82 est alimentée par les veilleuses à travers la résistance 83 ; la résistance 76 est connectée entre le circuit 63 et les veilleuses 43.

Les diodes 34, 35, 36 jouent le même rôle que dans la première réalisation.

De tels dispositifs permettent ainsi de signaler de manières différentes, différents défauts d'un dispositif de charge d'une batterie de véhicule automobile, indépendamment du régulateur.

De plus la seconde réalisation, outre son application à bord d'un véhicule, peut avantageusement être appliquée en tant qu'appareil de contrôle indépendant du véhicule grâce à sa pluralité de diodes qui permet d'affiner la connaissance de la tension de batterie et qui est de manipulation moins fragile qu'un voltmètre mécanique, dans ce cas évidemment le témoin 80 n'est pas nécessaire ainsi que les diodes 34 à 36.

REVENDICATIONS

1.-Dispositif témoin de charge d'une batterie de véhicule automobile, dont le dispositif de charge comporte notamment un alternateur (44) entraîné en rotation par une courroie elle même entraînée par un élément rotatif du moteur du véhicule et qui comporte un bobinage d'excitation commandé par un régulateur du type monofonction n'assurant que la régulation de la tension de la batterie, dispositif caractérisé en ce qu'il est connecté entre la clé de contact (42) du véhicule, la masse et une phase de l'alternateur (44) et comporte un témoin lumineux (41, 50) à intensité lumineuse variable et à couleur variable suivant l'importance d'un défaut éventuel du dispositif de charge ; des moyens de commande (80) de la variation de l'intensité lumineuse du témoin lumineux et des moyens de commande de la variation de la couleur dudit témoin lumineux.

2.- Dispositif selon la revendication 1 caractérisé en ce que le témoin lumineux est une diode bichromique (41).

3.- Dispositif selon la revendication 1 caractérisé en ce que le témoin lumineux est une rampe lumineuse (50) de diodes électroluminescentes ( 51 à 62) divisée en trois groupes de diodes, chaque groupe étant de couleur différente de celles des autres groupes.

4.- Dispositif selon les revendications 1 et 2 caractérisé en ce que les moyens de commande de la variation de couleur de la diode bichromique (41) sont constitués d'un générateur de tensions de références ($U_1$, $U'_1$ et $U'_2$) à partir d'une alimentation stabilisée (3,4) d'un pont diviseur (5,6,7,8) qui définit des tensions ($U_2$ et $U_3$) proportionnelles à la tension de batterie, d'un intégrateur (70) en une tension ($U_4$) de la tension d'une phase de l'alternateur (44), de comparateurs (37,38,39) qui comparent respectivement la tension ($U'_1$) à la tension ($U_2$), ($U'_2$) à ($U_3$) et ($U_1$) à ($U_4$), d'un oscillateur (49) disposé à la sortie des comparateurs, et d'un dispositif (48) de changement de sens de circulation du courant à travers la diode (41).

5.- Dispositif selon la revendication 4 caractérisé en ce que le dispositif (48) de changement de sens de circulation du courant à travers la diode (41) est constitué de deux transistors (26) et (31) dont les émetteurs sont connectés à la masse et les collecteurs à l'alimentation batterie par des résistances - (27,28,29), la base du transistor (26) à la sortie de l'oscillateur (49), la base du transistor (31) ou collecteur du transistor (26), et les connexions de la diode (41) respectivement aux collecteurs des deux transistors (26 et 31).

6.- Dispositif selon les revendications 1 et 3 caractérisé en ce que les moyens de commande de la variation de la couleur de la rampe lumineuse (50) sont constitués d'un générateur de tensions de références ($U_a$, $U_c$), d'un générateur d'une tension($U_b$) proportionnelle à la tension de batterie, d'un intégrateur (70) de la tension d'une phase de l'alternateur (44) dont la sortie est appliquée au point définissant la tension ($U_c$) et d'un analyseur (63) auquel sont appliquées les tensions ($U_a$, $U_b$, $U_c$) et qui les compare à des tensions qui lui sont internes définies par construction et alimente les diodes de la rampe lumineuse(50) connectées à sa sortie suivant un nombre correspondant à la tension de batterie.

7.- Dispositif selon la revendication 1 caractérisé en ce que les moyens de commande (80) de la variation de l'intensité lumineuse du témoin lumineux (41,50) sont constitués par une résistance (33,83) connectée entre les veilleuses (43) du véhicule et la base d'un transistor (32,82) dont le circuit émetteur-collecteur commande la tension appliquée au témoin lumineux - (41,50).

_FIG.1_

0156656

_FIG.2_

**0156656**

## Office europeen des brevets

## RAPPORT DE RECHERCHE EUROPEENNE

Numero de la demande

EP 85 40 0020

### DOCUMENTS CONSIDERES COMME PERTINENTS

| Categorie | Citation du document avec indication, en cas de besoin, des parties pertinentes | Revendication concernée | CLASSEMENT DE LA DEMANDE (Int Cl.4) |
|---|---|---|---|
| Y | DE-A-1 513 668 (VEB FAHRZEUGELEKTRIK KARL-MARX-STADT) * Page 2, ligne 29 - page 3, ligne 20; figures 1,2 * | 1,2 | H 02 J 7/14 G 01 R 31/36 |
| Y | ELEKTOR, no. 60, avril 1980, pages 30-31, Canterbury, GB; "Battery voltage indicator" * Article en entier * | 1,2 | |
| A | idem | 4 | |
| A | FR-A-2 509 474 (CENTRUL DE CERCETARE STIINTIFICA SI INGINERIE TEHNOLOGICA PENTRU SEMICONDUCTOARE) * Page 2, ligne 18 - page 4, ligne 33; figures 1,2 * | 1,4 | **DOMAINES TECHNIQUES RECHERCHES (Int Cl.4)** |
| A | FR-A-2 214 394 (SINTRA) * Page 5, ligne 16 - page 6, ligne 13; figure 1 * | 3,6 | H 02 J 7 G 01 R 31 H 05 B 33 G 08 B 5 |
| A | FR-A-2 207 425 (MATSUSHITA) * Page 7, ligne 9 - page 8, ligne 7; figure 6 * | 5 | |

Le present rapport de recherche a été etabli pour toutes les revendications

| Lieu de la recherche | Date d'achevement de la recherche | Examinateur |
|---|---|---|
| LA HAYE | 12-06-1985 | POINT A.G.F. |